# EUROPÄISCHE PATENTSCHRIFT

(11) **EP 0 643 153 B1**
(45) Veröffentlichungstag und Bekanntmachung des Hinweises auf die Patenterteilung: **19.06.1996**
(21) Anmeldenummer: 94113917.2
(22) Anmeldetag: 06.09.1994
(51) Int. Cl.: C23C 18/14

(54) **Verfahren zur Herstellung von strukturierten Metallisierungen auf Oberflächen**
Process for the fabrication of structured metallizations on surfaces
Procédé pour la fabrication de métallisations structurées sur surfaces

(30) Priorität: 09.09.1993 DE 4330961
(43) Veröffentlichungstag der Anmeldung: 15.03.1995
(73) Patentinhaber: KRONE Aktiengesellschaft, D-14167 Berlin (DE)
(72) Erfinder: Krabe, Detlef, Dr.-Phys., D-14471 Potsdam (DE)

(56) Entgegenhaltungen:
- EP-A- 0 534 576
- DE-A- 4 034 834
- METALLOBERFL CHE, Band 46, Nr. 5, 1992, Pforzheim W. PAATSCH "Keime mit dem Laser setzen" Seiten 213-217
- PROCEEDINGS-SPIE, Band 1598, September 1991, San Jose H.G. M LLER et al. "Laser process for personalization and repair of multi-chip- modules" Seiten 132-140

## Beschreibung

Die Erfindung bezieht sich auf ein Verfahren zur Herstellung von strukturierten Metallisierungen auf Oberflächen gemäß dem Oberbegriff des Anspruches 1.

Aus der DE-OS 40 34 834 ist ein Verfahren zur strukturierten Metallisierung vorbekannt, bei dem ein örtlich selektiv wirkender Laser einen transparenten Träger durchstrahlt. Auf dem Träger befindet sich eine metallorganische Verbindung. Der Laserstrahl zersetzt nach der Durchstrahlung des Trägers die metallorganische Schicht zu Metall, welches gleichzeitig verdampft und auf dem Substrat kondensiert. Das Substrat ist in einem definierten Abstand zum Träger angeordnet.

Nachteilig ist es hierbei, daß bereits die Herstellung der metallorganischen Schichten in einer nur unzureichenden Schichthomogenität gewährleistet werden kann. In der Regel bestehen die Schichten aus vielen Einzelkristalliten, so daß in Breite und Dicke unregelmäßige Metallschichten entstehen. Nur wenige metallorganische Verbindungen, wie z.B. Pd-Acetat, bilden unter definierten Bedingungen homogene amorphe Schichten, diese werden z.B. durch Trichlormethan-Lösungen erzeugt, was wenig umweltverträglich ist.

Die Zersetzung der metallorganischen Verbindung und die Bildung des Metalls führen des weiteren zu stark veränderten Absorptions- und Reflexionsverhältnissen, so daß auch hierdurch eine sehr inhomogene Schichtabscheidung bewirkt wird. Das gebildete Metall enthält außerdem Verunreinigungen durch organische Rückstände.

Es ist in dem bekannten Verfahren weiterhin nachteilig, daß eine Energiestrahlung notwendig ist, die eine fotochemische oder thermische Zersetzung der metallorganischen Schicht bewirkt. Das erfordert den Einsatz entweder von kostenintensiven Excimer-Lasern oder von Lasern, deren Wellenlänge den jeweiligen Absorptionsbedingungen der Schicht anzupassen ist.

Beim Transfer des Materials tritt durch den verfahrenstechnisch notwendigen Abstand zwischen Träger und Substrat eine Ausbreitung des Materials über die gewünschte Geometrie hinaus auf, wodurch sich die Kantenschärfe verringert und die minimale Strukturbreite zunimmt. Die in dem beschriebenen Verfahren genutzte metallorganische Verbindung muß im nachfolgenden chemisch-reduktiven Bad katalytisch wirken, um die beschriebene Metallisierung zu erreichen. Damit schränkt sich die Zahl der nutzbaren metallorganischen Verbindungen stark ein.

Strukturierte Metallisierungen werden üblicherweise auf fotolithografischem Wege hergestellt. Neben den dabei angewendeten Techniken kommt immer häufiger die Strahlung von Lasern zur Anwendung. Bekannte Verfahren zur additiven, strukturierten Metallisierung von Substratoberflächen mit Hilfe der Laserstrahlung arbeiten fast ausnahmslos mit einem relativ zur Substratoberfläche bewegten Laserstrahl. Die Verfahrgeschwindigkeit des Strahlfokus liegt dabei gewöhnlich unter 10 mm/s und ist vom verwendeten Precursor/Substrat-System sowie der erzeugten Metallschichtdicke abhängig. In den bekannten Precursorsystemen finden metallhaltige Verbindungen sowie Metallsuspensionen Anwendung, wobei die Ausführung der Systeme gasförmig in Rezipienten, flüssig in Küvetten oder fest in Schichten auf der Substratoberfläche sein kann.

Ein bekanntes Verfahren der Gasphasen-Abscheidung sieht Gold-Abscheidungen auf SiO₂ im Vakuum unter Verwendung eines Methyl(Triethylphosphin)Gold(I)-Dampfes und eines cw-Argon-Ionen-Lasers bei einer Schreibgeschwindigkeit von 0,0045 bis 0,035 mm/s vor (M.Jubber et al.: Appl.Surf.Sc.43 (1989),74-80). Nachteilig bei diesem Verfahren sind insbesondere die sehr geringe Schreibgeschwindigkeit und das notwendige aufwendige Vakuumsystem.

Bei D.Krabe, W.Radloff: Exp. Techn. d. Phys. 36 (1988) 6, 501-511, wird ein Flüssigphasen-Verfahren zur Silber-Abscheidung auf Glas in einem chemisch-reduktiven Silber-Bad in einer Küvette mittels eines cw-Argon-Ionen-Lasers beschrieben, welches eine Schreibgeschwindigkeit von 0,3 bis 1,3 mm/s erreicht.

Nachteilig bei diesem Verfahren ist es, daß der Precursor und das Substrat in einer Küvette angeordnet werden müssen, daß die Strahlführung und die Substrat-Behandlung durch die Küvette eingeschränkt sind und eine nur geringe Schreibgeschwindigkeit erreicht wird.

Ein Verfahren zur Aufbringung von Kupfer-Schichten auf MCM-Substraten mit Polyimid-Beschichtung wird bei H.G. Müller et al.: SPIE 1598 (1991), 132-140, beschrieben.

Nachteilig ist es, daß die eingesetzte wäßrige Kupfer-Formiat-Lösung eine hohe Oberflächenspannung aufweist, wodurch eine homogene Benetzung der Substratoberfläche und damit eine homogene Ausbildung der metallorganischen Precursorschicht nur schwer erreicht werden kann. Die Benetzung kann durch einen Zusatz von Glycerin verbessert werden. Gleichzeitig verlängert sich jedoch die Trockenzeit. Der für die Ausbildung der metallorganischen Precursorschicht erforderliche Trocknungsschritt ist allgemein langandauernd und nur mit Aufwand, z.B. durch den Einsatz eines Ofens, verkürzbar. Das Verfahren weist zudem nur eine geringe Schreibgeschwindigkeit des eingesetzten Lasers von ca. 0,1 mm/s auf.

Ein weiteres Verfahren beschreibt die Verankerung von Metallteilchen auf Keramiksubstraten (W.Paatsch: Metalloberfläche 44 (1992) 5, 213-217). Es wird vorgeschlagen, die Metallteilchen in einer Suspension im Spin-On- oder Sprühverfahren auf die Oberfläche zu bringen und nach der Bestrahlung mit einem Laser, die nicht haftenden Metallteilchen abzuspülen. Die Verstärkung der eingebrannten, haftenden Metallteilchen erfolgt in chemisch-reduktiven Bädern.

Nachteilig ist die beschränkte Anwendbarkeit des Verfahrens nur auf temperaturstabile Materialien, wie z.B. Keramik, da die Metallteilchen auf der Substratoberfläche auf- oder/und eingeschmolzen werden, und der für das Aufbringen der metallorganischen Precursorschicht notwendige zusätzliche Spin-On- oder Sprühverfahrensschritt sowie die geringe Schreibgeschwindigkeit unter 50 mm/s.

Von daher ist es die Aufgabe der Erfindung, ein Verfahren der gattungsgemäßen Art zu entwickeln, mit dem eine strukturierte Metallisierung von transparenten und nichttransparenten Oberflächen ohne die üblichen fotolithographischen Prozesse und ohne aufwendiges Handling für Gase, Flüssigkeiten oder metallorganische Schichten, also ohne Vakuumanlage oder Küvetten, mit wesentlich höherer Schreibgeschwindigkeit als bisher erreichbar, ermöglicht wird und das eine große Anwendungsvielfalt gewährleistet.

Die Lösung dieser Aufgabe ergibt sich aus den kennzeichnenden Merkmalen des Anspruches 1. Das Verfahren erlaubt eine strukturierte Metallisierung von Substraten ohne die aufwendigen fotolithografischen Prozesse mit den dabei erforderlichen Masken. Der Einsatz einer sehr einfach handhabbaren Metallbeschichtung für die strukturierte Laser-Bekeimung erlaubt die Bekeimung auch von transparenten Substraten. Es können z.B. transparente Substrate an LCD-Zellen metallisiert werden. Das aufwendige Handling für Gase, Flüssigkeiten oder metallorganische Schichten wird nicht benötigt.

Durch die Belegung des transparenten Trägers mit einer dünnen, sehr homogenen Metallschicht oder Metallschichtfolge wird die Zersetzung einer metallorganischen Schicht erfindungsgemäß umgangen. Die dünnen metallischen Schichten können z.B. durch konventionelle Bedampfungs- oder Sputterverfahren hergestellt und als Halbzeug billig und in hoher Qualität bezogen werden. Die bereits auf dem Träger ausgebildete dünne Metallschicht bietet einheitliche optische Parameter für die Bestrahlung. Die Bestrahlung kann z.B. mit einem gepulsten Nd:YAG-Laser erfolgen, wobei der Transferprozeß stets thermisch initiiert ist und auf der gesamten Fläche bei gleichen optischen und thermischen Bedingungen abläuft. Verunreinigungen durch Reaktionsrückstände treten nicht auf. Dadurch, daß die dünne Metallschicht auf dem transparenten Träger in möglichst innigen Kontakt mit der Substratoberfläche gebracht wird, kann das Transfer- und Kondensationsgebiet weitgehend minimiert werden. Die auf den Träger aufgebrachte dünne Metallschicht kann z.B. aus einem haftvermittelnden und einem weiteren Metall bestehen, welches im nachfolgenden chemisch-reduktiven Bad katalytisch wirkt, so daß die gewünschte Metallisierung ohne Einschränkungen erfolgen kann. Der laserinduzierte Transferprozeß führt zu einer Durchmischung der Metalle. Beim Einbringen in das chemisch-reduktive Bad entstehen im nachgelagerten Verfahrensschritt dadurch in der transferierten Bekeimungsschicht auf der Substratoberfläche mikrogalvanische Zellen, welche, im Unterschied zu einer katalytisch initiierten Schichtabscheidung, ebenfalls die Bildung erster Keime der Metallisierung bewirken können. Das weitere Schichtwachstum führt zu den für chemische Schichtabscheidungen üblichen guten Schichtqualitäten bei einer sehr guten Haftfestigkeit.

Die Nutzung dünner Metall- und Keimschichten läßt sehr hohe, bei laserinduzierten Metallisierungen bislang nicht erreichte Schreibgeschwindigkeit bei einer einfachen Prozeßführung zu. Das in der Erfindung beschriebene Verfahren stellt daher ein sehr wirtschaftliches Verfahren der additiven Laserstrukturierung dar. Die mit dem Verfahren erzeugten Metallschichten zeigen sehr gute Haftungseigenschaften, insbesondere auch auf ITO (Indium-Tin-Oxid-Schicht) und auf Glasoberflächen z.B. von LCD-Zellen. Die nach der Bekeimung der Oberfläche erfolgte Metallisierung in Bädern kann als Massenprozeß organisiert werden.

Weitere vorteilhafte Ausgestaltungen der Erfindung ergeben sich aus den Unteransprüchen.

Die Erfindung ist nachfolgend anhand von in den Zeichnungen dargestellten Ausführungsbeispielen näher erläutert. Es zeigen:
- Fig. 1: die schematische Darstellung der Laserbekeimung der ITO-Oberfläche einer LCD-Zelle,
- Fig. 2: die schematische Darstellung der bekeimten ITO-Oberfläche nach Fig.1,
- Fig. 3: die schematische Darstellung der Metallisierung der ITO-Oberfläche nach den Fig.1 und 2,
- Fig. 4: die schematische Darstellung der Laserbekeimung des Stirnkantenbereiches einer LCD-Zelle und
- Fig. 5: die schematische Darstellung des Metallisierens der Bekeimungsschicht an der Stirnkantenoberfläche der LCD-Zelle nach Fig.4.

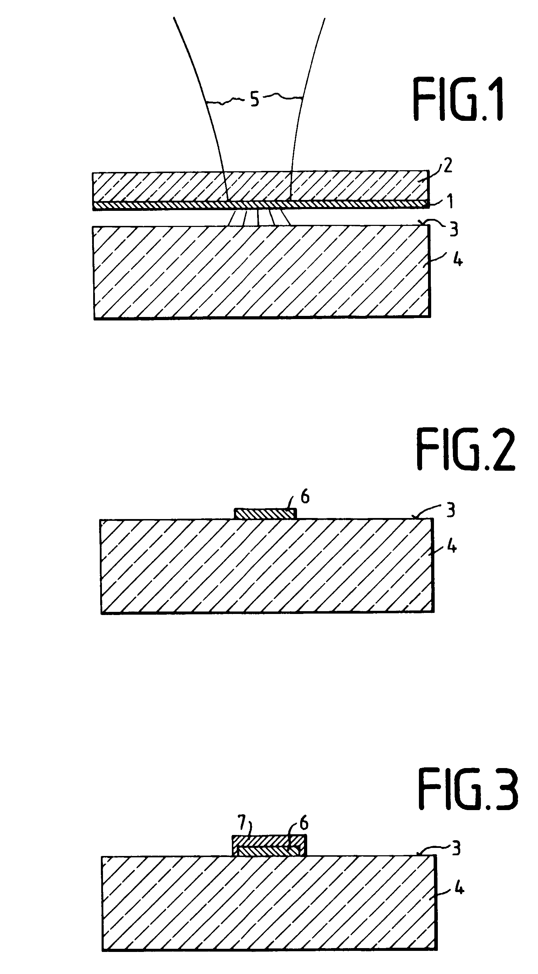

In den Figuren 1 bis 3 ist das Verfahren zur strukturierten Metallisierung einer als ITO-Oberfläche ausgebildeten Substratoberfläche 3 an LCD-Zellen dargestellt (Herstellung von Metallkontakten für LCD-Zellen).

In der Fig. 1 ist die Laserbekeimung der Substratoberfläche 3, hier der ITO-Oberfläche einer LCD-Zelle, mittels eines gepulsten Laserstrahles 5, beispielsweise eines Nd: YAG-Laserstrahles mit einer mittleren Leistung von ca. 200 mW und einer Schreibgeschwindigkeit von ca. 10 cm/s, gezeigt.

Auf einen Glasträger 2 ist eine dünne homogene Metallbeschichtung 1 aufgebracht, die beispielsweise aus einer haftvermittelnden Schicht aus Ti:W in einer Schichtdicke von 230 nm und aus einer katalytisch wirkenden Schicht aus Gold in einer Schichtdicke von 200 nm gebildet ist. Der Glasträger 2 wird mit der Metallbeschichtung 1 über die zu metallisierende Substratoberfläche 3 gebracht und mit dem gepulsten Nd:YAG-Laserstrahl 5 bestrahlt. Dabei kann die Bestrahlung sowohl durch den Glasträger 2 mit der Metallbeschichtung 1 als auch durch das transparente Glas oder/und ITO der LCD-Zelle erfolgen. Der Transfer des Materials erfolgt durch Laserverdampfung der Metallbeschichtung 1 und nachfolgender Kondensation auf der LCD-Oberfläche, hier gemäß der Darstellung in der Fig.2 als Keimschicht 6. Nach erfolgter selektiver Bekeimung der Substratoberfläche 3, also der LCD-Oberfläche, wird entsprechend der Darstellung in der Fig. 3 eine Metallisierung der bekeimten Bereiche 6 mit einer Metallisierungsschicht 7 in einem chemisch-reduktiven Bad, z.B. einem Nickel-Bad, vorgenommen. Bei einer Badtemperatur von 95°C und einer Dauer von 7 Minuten bildet sich eine ca.2,5 µm dicke NiP-Struktur aus.

Die zu beschichtenden Substrate können auch nicht-transparent sein, z.B. Keramiken.

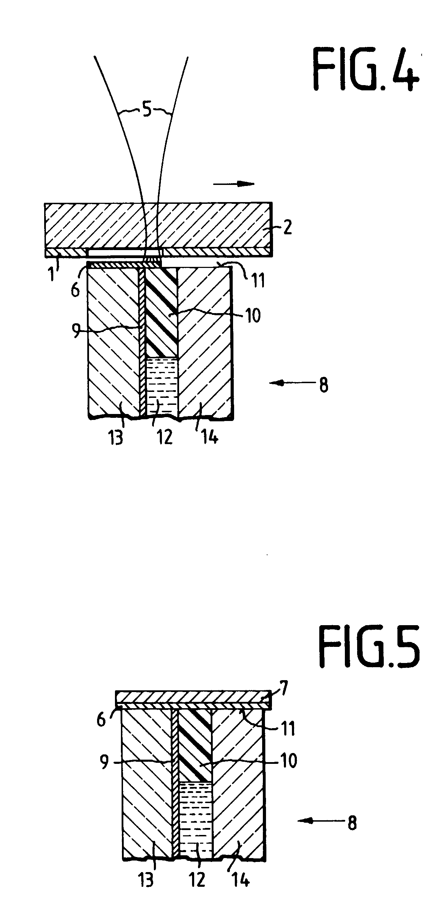

In den Fig. 4 und 5 ist das Verfahren in der Anwendung zur Herstellung von Stirnseitenkontaktierungen bei Flachdisplays, hier einer Flüssigkristall-Zelle 8, gezeigt.

Großflächige Flüssigkristallanzeigen sind als ein modulares System aus einzelnen Anzeigeelementen oder Zellen aufgebaut. Die Zellen sind über Kontaktierungsflächen mit der Ansteuerelektronik verbunden. Ankontaktierungen von Flachdisplays werden dabei sehr oft in der Form ausgeführt, daß die Elektroden seitlich aus den Stirnkanten herausgeführt werden. Als Träger dienen die Deck- oder Rückgläser, die über den Rahmen der Anzeige hinausragen und dadurch die Gesamtabmessungen vergrößern. Im herausgeführten Elektrodenbereich werden dann durch leitfähige Kleber, leitfähige Elastomere oder durch löt- oder/und bondbare Metallisierungen die Kontaktierungen mit Verdrahtungsträgern der Ansteuerelektronik hergestellt. Sollen löt- oder bondbare Metallisierungen eingesetzt werden, so müssen diese in konventioneller fotolithografischer Strukturierungstechnik vor dem Assemblieren der Zelle auf die Front- und/oder Rückgläser gebracht werden, da die technologischen Belastungen im Prozeß für die fertigen Zellen zu groß wären und zu irreversiblen Schäden führen würden.

Durch die Kontaktierung und Metallisierung an der Stirnkante 11 der Zelle 8 mittels des erfindungsgemäßen Verfahrens durch Laser-Transfer-Bekeimung mit örtlich selektiver Metallisierung in Bädern wird der Kontaktbereich von Anzeigen entscheidend verkleinert und damit die aktive Fläche der Anzeige vergrößert. Es werden keine aufwendigen fotolithografischen Prozesse notwendig, so daß sich an assemblierten Displays eine lötfähige Metallisierung herstellen läßt.

Die Fig. 4 zeigt einen senkrechten Schnitt durch den Randbereich der Flüssigkristall-Zelle 8 mit einer elektrisch leitenden Schicht 9. Die Flüssigkristall-Zelle 8 besteht vereinfacht dargestellt bekannterweise aus Glasträgern 13,14, der lichtdurchlässigen elektrisch leitenden Schicht 9, einem abdichtenden Rahmen 10 und einer Flüssigkristallschicht 12. Die elektrisch leitende Schicht 9 ist zum Anschluß einer nicht dargestellten Ansteuerelektronik zwischen dem Glasträger 13 und dem Rahmen 10 bis zur Stirnkantenoberfläche 11 der Zelle 8 nach außen geführt.

Die Laserbekeimung der Stirnkantenoberfläche 11 der Zelle 8 erfolgt mittels des gepulsten Laserstrahls 5 in der vorher beschriebenen Art und Weise.

Auf den Glasträger 2 ist die dünne homogene Metallbeschichtung 1 aufgebracht, die beispielsweise aus einer haftvermittelnden Schicht aus Ti:W und aus einer katalytisch wirkenden Schicht aus Gold gebildet ist. Der Glasträger 2 mit der Metallbeschichtung 1 wird über die zu metallisierende Stirnkantenoberfläche 11 gebracht und mit dem gepulsten Nd:YAG-Laserstrahl 5 bestrahlt. Der Transfer des Materials erfolgt durch Laserverdampfung der Metallbeschichtung 1 und nachfolgender Kondensation auf der Stirnkantenoberfläche 11 als Keimschicht 6. Nach erfolgter Bekeimung der Stirnkantenoberfläche 11 wird eine Metallisierung der bekeimten Bereiche mit einer Metallisierungsschicht 7 entsprechend der Darstellung in der Fig. 5 in einem chemisch-reduktiven Bad vorgenommen. Durch eine geeignete Badauswahl lassen sich die gewünschten lötfähigen Metallisierungssysteme herstellen. Der auf die Stirnkantenoberfläche 11 einfallende Laserstrahl 5 bewirkt gleichzeitig mit dem Aufdampfen der Bekeimungsschicht 6 eine Modifikation der Oberfläche 11, die gezielt dazu genutzt werden kann, eine zusätzliche mechanische Haftung zu bewirken.

Die Laser-Transfer-Bekeimung kann auch zusammengefaßt an mehreren Stirnkantenoberflächen 11 gleichzeitig ausgeführt werden. Die Metallisierung erfolgt nach der Bekeimung in Bädern als Massenprozeß.

Durch die Anwendung des Verfahrens bei der Kontaktierung von Anzeigen können die üblich überstehenden und zur Kontaktierung erforderlichen Randbereiche der Zellen entweder bereits bei der Zellenfertigung weggelassen oder anschließend beispielsweise mit einer Wafersäge abgeschnitten werden, wobei die Leiterzüge der Zellen (z.B. ITO-Leiterbahnen) bis zu den Stirnkantenoberflächen gezogen sind.

Ein weiteres Anwendungsgebiet des Verfahrens ist die Ausbildung von Leiterstrukturen auf flexiblen Pl-Folien, z.B. zur Herstellung von flexiblen Schaltungsträgern auf Polyimidbasis (Pl). Auch hier erfolgt zunächst die laserinduzierte Bekeimung der Oberfläche durch eine Lasertransfertechnik. Nachfolgend wird die strukturierte Bekeimung in einem Metallisierungsbad verstärkt.

Wie im ersten Ausführungsbeispiel ist auch hierbei die auf den Glasträger 2 aufgebrachte Metallbeschichtung 1 der Ausgangspunkt für das Verfahren. Die Metallbeschichtung 1 besteht ebenfalls aus einer haftvermittelnden und aus einer katalytisch wirkenden Schicht. Der Glasträger 2 wird mit der Metallbeschichtung 1 über die zu metallisierende Pl-Oberfläche gebracht und danach mit einem gepulsten Laserstrahl bestrahlt. Der Transfer des Materials erfolgt so wie im ersten Ausführungsbeispiel beschrieben. Nach erfolgter selektiver Bekeimung der Pl-Oberfläche wird eine Metallisierung der bekeimten Bereiche in einem chemisch-reduktiven Kupfer-Bad vorgenommen. Bei einer Bad-temperatur von 60°C und einer Dauer von ca. 60 Minuten scheidet sich eine ca. 5 µm dicke, strukturierte Kupfer-Schicht ab. In den beispielhaft dargestellten Ausführungsfällen kann sich nach der laserinduzierten Bekeimung der Substratoberfläche eine Spülung der bekeimten Substratoberfläche mit deionisiertem Wasser als günstig erweisen.

## Patentansprüche

1. Verfahren zur Herstellung von strukturierten Metallisierungen auf Oberflächen mittels Laserstrahl und eines mit Beschichtungen versehenen transparenten Trägers sowie durch ein chemisch-reduktives Bad,
**dadurch gekennzeichnet,**
daß der transparente Träger (2) mit einer dünnen, homogenen Metallbeschichtung (1) versehen wird und mit der Metallbeschichtung (1) in engen Kontakt mit der zu metallisierenden Substratoberfläche (3) gebracht und danach mit dem gepulsten Laserstrahl (5) bestrahlt wird, wobei der Transfer des Metalls vom transparenten Träger (2) durch Laserverdampfung und nachfolgender Kondensation auf der Substratoberfläche (3) erfolgt, und daß nach der selektiven Bekeimung der Substratoberfläche (3) die Metallisierung der bekeimten Bereiche (6) im chemisch-reduktiven Bad durchgeführt wird.

2. Verfahren nach Anspruch 1, dadurch gekennzeichnet, daß für das Substrat Keramik oder ein Polymer ausgewählt werden.

3. Verfahren nach Anspruch 1, dadurch gekennzeichnet, daß die zu metallisierende Substratoberfläche (3) durch eine Stirnkantenoberfläche (11) mit einer bis an die Stirnkantenoberfläche (11) herangezogenen elektrisch leitenden Schicht (9) einer Flüssigkristall-Zelle (8) gebildet wird.

4. Verfahren nach den Ansprüchen 1 bis 3, dadurch gekennzeichnet, daß die selektive Bekeimung programmiert wird.

5. Verfahren nach den Ansprüchen 1 bis 4, dadurch gekennzeichnet, daß die dünne homogene Metallbeschichtung aus einer haftvermittelnden und/oder einer katalytisch wirksamen Substanz gebildet wird.

6. Verfahren nach den Ansprüchen 1 bis 5, dadurch gekennzeichnet, daß die bekeimte Substratoberfläche (3,11) mit entionisiertem Wasser gespült wird.

## Claims

1. A process for the fabrication of structured metallizations on surfaces by means of a laser beam and a transparent carrier provided with coatings and by a chemical-reductive bath, characterized by that the transparent carrier (2) is provided with a thin homogeneous metal coating (1) and brought with the metal coating (1) into a close contact with the surface (3) to be metallized and is then irradiated by the pulsed laser beam (5), transfer of the metal from the transparent carrier (2) being achieved by laser evaporation and subsequent condensation on the substrate surface (3), and that after the selective seeding of substrate surface (3), metallization of the seeded zones (6) is performed in a chemical-reductive bath.

2. A process according to claim 1, characterized by that for the substrate are chosen ceramic or a polymer.

3. A process according to claim 1, characterized by that the substrate surface (3) to be metallized is formed by a front-edge surface (11) with an electrically conductive layer (9) of a liquid crystal cell (8), said layer (9) extending up to the front-edge surface (11).

4. A process according to claims 1 to 3, characterized by that the selective seeding is programmed.

5. A process according to claims 1 to 4, characterized by that the thin homogeneous metal coating is formed of a substance improving adhesion and/or a catalytically acting substance.

6. A process according to claims 1 to 5, characterized by that the seeded substrate surface (3, 11) is rinsed with deionized water.

## Revendications

1. Procédé pour la fabrication de métallisations structurées sur surfaces au moyen d'un rayon de laser et d'un support transparent pourvu de revêtements et par un bain chimique-réductif,
caractérisé en ce que le support transparent (2) est pourvu d'un revêtement en métal (1) mince homogène et mis avec le revêtement en métal (1) en contact étroit avec la surface du substrat (3) à métalliser et est puis irradié par le rayon de laser (5) en régime pulsé, le transfert du métal à partir du support transparent (2) se faisant par évaporation à laser et condensation subséquente sur la surface du substrat (3), et qu'après la germination sélective de la surface du substrat (3) la métallisation des zones germées (6) est exécutée dans le bain chimique-réductif.

2. Procédé selon la revendication 1,
caractérisé en ce que pour le substrat on peut choisir céramqiue ou un polymère.

3. Procédé selon la revendication 1,
caractérisé en ce que la surface du substrat (3) à métalliser est formée par une surface d'arête de devant (11) avec une couche électriquement conductive (9) d'une cellule d'affichage à cristaux liquides (8), ladite couche (9) s'étendant jusqu'à la surface d'arête de devant (11).

4. Procédé selon les revendications 1 à 3,
caractérisé en ce que la germination sélective est programmée.

5. Procédé selon les revendications 1 à 4,
caractérisé en ce que le revêtement en métal mince homogène est formé par une substance favorisant l'adhésion et/ou agissant en manière catalytique.

6. Procédé selon les revendications 1 à 5,
caractérisé en ce que la surface germée du substrat est rincée avec eau déionisée.
